# EUROPÄISCHE PATENTANMELDUNG

(11) **EP 3 153 821 A1**
(43) Veröffentlichungstag der Anmeldung: **12.04.2017**
(21) Anmeldenummer: 16193038.3
(22) Anmeldetag: 10.10.2016
(51) Int. Cl.: G01D 5/14, G01R 33/09, G01D 11/24, G01D 11/30

(54) **SENSORANORDNUNG**

(30) Priorität: 09.10.2015 DE 102015117231; 06.10.2016 DE 102016119003
(71) Anmelder: Siko GmbH, 79256 Buchenbach (DE)
(72) Erfinder: WIESSLER, Andreas, 79254 Oberried (DE); FRÖHNER, Thomas, 79312 Emmendingen-Mundingen (DE)
(74) Vertreter: Patentanwälte und Rechtsanwalt Weiß, Arat & Partner mbB

(57) **Zusammenfassung**

Die Erfindung betrifft eine Sensoranordnung zur Detektion von Gegenständen in einer Maschinenfertigungsanlage, wobei darin ein erster Magnetsensor angeordnet ist, wobei in der Sensoranordnung ein weiterer Magnetsensor angeordnet ist und der Abstand des ersten Magnetsensors zu dem weiteren Magnetsensor an die Teilung des verwendeten Maßstabes angepasst ist.

## Beschreibung

### Technisches Gebiet

Sensoranordnung zur Detektion von Gegenständen in einer Maschinenfertigungsanlage.

### Stand der Technik

Aus dem Stand der Technik wird auf die DE 10 2011 017 761 A1 hingewiesen, welche einen Sensor zur Erfassung eines elektrischen Feldes nutzt.

Weiter wird auf die DE 199 28 557 A1 hingewiesen, welche ein Magnetfeld aufweist, welche durch Induktion erzeugt wird.

Daneben wird auch auf die DE 10 2007 002 221 A1 hingewiesen, welche eine Positionserfassung mittels Erfassung der Magnetfeldstärke durch einen bewegten Magneten mit einem Polpaar und zwei Magnetsensoren aufweist.

Bislang werden zur Detektion von Gegenständen in einer Maschinenfertigungsanlage periodische magnetische Massstäbe mit längenangepassten Magnetsensoren, die die Feldrichtung bzw. Feldstärke erfassen, verwendet. Diese Magnetsensoren können nur in Verbindung mit einer festen Periodenlänge des Massstabes verwendet werden. Alternativ können auch Magnetsensoren verwendet werden, die in einem Punkt die x- und y- Komponente der Feldrichtung /Feldstärke messen können, zum Beispiel Winkelsensoren. Üblicherweise liefern längenangepasste Magnetsensoren bereits sinus- und cosinusförmige Analogsignale. Durch arcus-tangens-Interpolation, über ASIC oder µController, wird der Positionswert ermittelt. Der Signalverlauf kann durch die geometrische Form des Massstabes, wie Pollänge oder Massstabsdicke, zum Teil stark eingeschränkt werden. Dies reduziert die Genauigkeit des ermittelten Positionswertes zum Teil erheblich.

### Offenbarung der Erfindung

### Aufgabe

Aufgabe der vorliegenden Erfindung ist es eine Sensoranordnung zur Verfügung zu stellen, welche eine Erhöhung der Messgenauigkeit erreicht, indem diese den Bedürfnissen des Nutzers entgegenkommt und angepasst wird. Die Sensoranordnung soll über längere Zeit autark und wartungsfrei sein.

### Lösung der Aufgabe

Diese Aufgabe wird durch die Merkmale nach Anspruch 1 gelöst.

Die Lösung der Aufgabe erfolgt dadurch, dass ein erster und weiterer Magnetsensor, wie zum Beispiel TMR-, AMR- oder GMR-Sensoren in einer Sensoranordnung angeordnet werden. Es handelt sich hier bevorzugt um Permanentmagnete.

Eine erfindungsgemäße Sensoranordnung zur Detektion von Gegenständen in einer Maschinenfertigungsanlage weist einen ersten Magnetsensor in einem Gehäuse auf. Ausserdem ist in dem Gehäuse ein weiterer Magnetsensor angeordnet. Ein Abstand des ersten Magnetsensors zu dem weiteren Magnetsensor ist an die Teilung des verwendeten Massstabes angepasst. Das bedeutet im Einzelnen, dass der Massstab eine periodische magnetische Teilung auf.

TMR-Sensoren (tunneling magnetoresistance) weisen sich durch ein starkes Ausgangssignal aus, welches keinen Verstärker benötigt. Sie haben eine sehr hohe Beständigkeit, verbrauchen nur sehr wenig Strom und verfügen über jeweils einen Sinus- und Cosinusausgang für die Richtungserkennung. Zudem besteht eine hohe Toleranz bei variierenden Größen des Luftspaltes zwischen dem magnetischem Massstab und dem Sensor. Dies ermöglicht einen flexiblen Anwendungsbereich.

AMR-Sensoren (anisotropic magnetoresistiver Sensor) weisen ebenfalls eine hohe Messgenauigkeit bei vergleichsweise auch großen Luftspalten zwischen Sensor und magnetischem Massstab auf. Der Stromverbrauch ist geringen und zugleich ist die vollständige Funktionalität selbst bei Temperaturschwankungen zwischen -40° C und +150° C gegeben. Die Wegdifferenzen der Hysterese ist vernachlässigbar. AMR-Sensoren enthalten zwei wheatstonische Messbrücken und ebenfalls einen Sinus- und einen Cosinusausgang.

Weiterhin ist entsprechend der Anforderungen der Messungen auch ein GMR-Sensor (giant magneto-resistive) einsetzbar. Im Unterschied zu anderen magneto-resistiven Verfahren lieg hier ein Funktionsweise vor, bei der der Elektronen-Spin-Effekt in einem ultradünnen Schichtsystem ausgenutzt wird, der die Leitungsmechanismen verändert.

Je nachdem welche Anforderungen ein Nutzer in Bezug auf die vorzunehmende Messungen hat, und welche Messbedingungen vorliegen, wird die entsprechend vorteilhafteste Magnetsensorart in einer Sensoreinheit verbaut. Dabei wird zudem der individuell festlegbare Abstand der einzelnen Magnetsensoren zueinander nutzerdefiniert festgelegt.

Die Magnetsensoren werden in einem bestimmten, von einem Nutzer definierten Abstand zueinander angeordnet. Durch die Nutzung von mehr als einem Magnetsensor wird die Messgenauigkeit im Vergleich zu Systemen mit nur einem Magnetsensor deutlich erhöht. Darüber hinaus sind TMR-, AMR-oder GMR-Sensoren sehr kostengünstig und benötigen nur wenig Strom.

Der Abstand der Magnetsensoren in der Sensoranordnung kann zwischen 0,5 mm und 50 mm betragen. Dieser Abstand wird nach den Vorgaben und Wünschen der Nutzer individuell festgelegt. Durch die Anordnung eines ersten und eines weiteren Magnetsensors in einem bestimmten Abstand, kann auf unterschiedliche magnetische Massstäbe reagiert werden. Beispielsweise kann durch die Definierbarkeit des Abstandes der Magnetsensoren zueinander neben dem metrischen auch das angloamerikanische Masssystem berücksichtigt werden. Hier entfallen meist fehlerbehaftete Umrechnungen. Je nach Massstab wird eine individuell angepasste Sensoranordnung verwendet.

Neben einem ersten und einem weiteren Magnetsensor ist in der Sensoranordnung eine Anzeige integriert. Vielmehr ist der erste Magnetsensor und der weitere Magnetsensor in einem Gehäuse angeordnet. Die Anzeige ist ein LCD. Vorteilhaft daran ist, dass ein LCD kostengünstig ist, sehr wenig Strom verbraucht und zuverlässig arbeitet.

Weiterhin umfasst die Sensoranordnung eine Anzeigeelektronik, welche die von den Magnetsensoren übermittelten Daten in Werte, die auf der Anzeige angezeigt werden, umrechnet.

Die magnetempfindlichen Sensoren, die Anzeigeelektronik und die Anzeige sind mit einer ebenfalls in der Sensoranordnung integrierten, handelsüblichen Batterie verbunden. Diese stellt die Stromversorgung der aufgeführten Bauteil über mehrere Jahr hinweg sicher. Eine externe Energieversorgung ist daher nicht vorgesehen. Dies erleichtert den Ein- und Ausbau in eine Maschinenfertigungsanlage und macht die Sensoranordnung autark.

Die Sensoreinheit ist einfach aufgebaut, kostengünstig herzustellen und leicht in eine Maschinenfertigungsanlage ein- und ausbaubar. Dabei hängt die maximale Funktionsdauer von der Leistung der integrierten Batterie ab. Ein Austausch der Batterie ist aufgrund der günstigen Produktion und der kompakten und geschlossenen Ausführung der Sensoranordnung nicht vorgesehen.

Nimmt die Leistung der Batterie ab, wird dies über die Anzeige vermittelt. Durch die kostengünstige und kompakte Bauweise wird dann die gesamte Sensoranordnung ausgewechselt.

Mit dieser erfindungsgemässen Sensoranordnung kann eine über mehrere Jahre andauernde autarke, wartungsfreie, individuell angepasste und zuverlässige Funktionalität gewährleistet werden.

Die jeweils in der Sensoranordnung verbauten Magnetsensoren weisen den gleichen Kanal auf, was bedeutet, dass das Signal mit der gleichen Feldempfindlichkeitsrichtung vorliegt. Hier müssen keine unterschiedlichen Einstellungen oder Umrechnungen vorgenommen werden. Die Messgenauigkeit wird dadurch erhöht, Umrechnungsfehler treten nicht auf.

Das Signal der Magnetsensoren ist 90° phasenversetzt, was bedeutet, dass ein Versatz von einem ¼ der Periodenlänge des Sensorsignals vorliegt.

Der Gesamtstromverbrauch der Sensoranordnung ist vergleichsweise sehr niedrig, da Low-power-Sensoren, wie TMR-, AMR-und /oder GMR-Sensoren sowie µC und/oder ASIC in CMOS-Technologie verwendet werden und die Anzeige ein stromsparender Flüssigkristallbildschirm (LCD) ist. Dadurch ist die individuell angepasste Sensoranordnung auch sehr kostengünstig und leicht zu ersetzen.

### Figurenbeschreibung

Weitere Vorteile, Merkmale und Einzelheiten der Erfindung ergeben sich aus der nachfolgenden Beschreibung eines Ausführungsbeispiel anhand einer Figur.

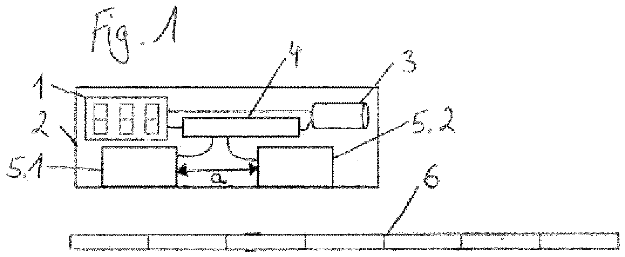

Figur 1 zeigt eine stark schematisierte Darstellung einer Sensoranordnung 2 deren Seitenwände durchsichtig dargestellt sind und einen magnetisierten Massstab 6. Die Sensoranordnung dient zur Detektion von Gegenständen in einer Maschinenfertigungsanlage, wobei ein erster Magnetsensor 5.1 in einem Gehäuse angeordnet ist, wobei in dem Gehäuse ein weiterer Magnetsensor 5.2 angeordnet ist und der Abstand a des ersten Magnetsensors 5.1 zu dem weiteren Magnetsensor 5.2 an die Teilung des verwendeten Massstabes 6 angepasst ist. Das bedeutet, dass der Abstand a je nach Teilung bzw. Aufteilung des verwendeten Massstabes 6 variierbar ist. Somit ist der Abstand a des ersten Magnetsensors 5.1 zu dem weiteren Magnetsensor 5.2 variierbar.

Die in Figur 1 schematisch dargestellte Sensoranordnung 2 umfasst in dieser Ausführungsform den ersten Magnetsensor 5.1 und im Abstand a den weiteren Magnetsensor 5.2. Der Abstand a wird bei der Fertigung der Sensoranordnung 2 nach den Wünschen eines Nutzers nach einem entsprechenden magnetisierten Massstab 6 definiert. Der Abstand a kann dabei in einem Abstand zwischen 0,5 mm und 50 mm festgelegt werden. Es ist auch vorgesehen, dass noch weitere Magnetsensoren in der Sensoranordnung nach dem gleichen Prinzip angeordnet werden können.

Weiterhin umfasst die Sensoranordnung 2 eine Anzeige 1. Diese Anzeige verfügt in diesem Ausführungsbeispiel über drei Stellen, die Anzahl der Stellen kann jedoch anwendungsbeding variieren. Die Anzeige 1 ist ein LCD. Dieser LCD ist für die Stromversorgung mit einer Batterie 3 verbunden. Die LCD Anzeige 1 verbraucht nur sehr wenig Strom.

Weiterhin ist in der Sensoranordnung 1 eine Anzeigeelektronik 4 angeordnet. Diese ist sowohl mit dem ersten und dem weiteren Magnetsensor 5.1 und 5.2 verbunden, als auch mit der Batterie 3 und der Anzeige 1. Die Anzeigeelektronik wandelt die von den angeordneten Magnetsensoren 5.1 und 5.2 erfassten Signale um, sodass diese über die Anzeige 1 angezeigt werden können.

**Bezugszeichenliste**

| | | | | | |
|---|---|---|---|---|---|
| 1 | Anzeige | 34 | | 67 | |
| 2 | Sensoranordnung | 35 | | 68 | |
| 3 | Batterie | 36 | | 69 | |
| 4 | Anzeigeelektronik | 37 | | 70 | |
| 5.1 | erster Magnetsensor | | | | |
| 5.2 | weiterer Magnetsensor | 38 | | 71 | |
| 6 | magnetisierter Massstab | 39 | | 72 | |
| a | Abstande zwischen erstem und weiterem Magnetsensor | 40 | | 73 | |
| | | 41 | | 74 | |
| | | 42 | | 75 | |
| | | 43 | | 76 | |
| | | 44 | | 77 | |
| | | 45 | | 78 | |
| 13 | | 46 | | 79 | |
| 14 | | 47 | | 80 | |
| 15 | | 48 | | | |
| 16 | | 49 | | | |
| 17 | | 50 | | | |
| 18 | | 51 | | | |
| 19 | | 52 | | | |
| 20 | | 53 | | | |
| 21 | | 54 | | | |
| 22 | | 55 | | | |
| 23 | | 56 | | | |
| 24 | | 57 | | | |
| 25 | | 58 | | | |
| 26 | | 59 | | | |
| 27 | | 60 | | | |
| 28 | | 61 | | | |
| 29 | | 62 | | | |
| 30 | | 63 | | | |
| 31 | | 64 | | | |
| 32 | | 65 | | | |
| 33 | | 66 | | | |

## Patentansprüche

1. Sensoranordnung (2) zur Detektion von Gegenständen in einer Maschinenfertigungsanlage, wobei ein erster Magnetsensor (5.1) in einem Gehäuse angeordnet ist,
**dadurch gekennzeichnet,**
**dass** in dem Gehäuse ein weiterer Magnetsensor (5.2) angeordnet ist und der Abstand (a) des ersten Magnetsensors (5.1) zu dem weiteren Magnetsensor (5.2) an die Teilung des verwendeten Maßstabes angepasst ist.

2. Sensoranordnung (2) nach Anspruch 1, **dadurch gekennzeichnet, dass** es sich bei dem ersten und dem weiteren Magnetsensor (5.1, 5.2) um einen TMR und/oder AMR-Sensor handelt.

3. Sensoranordnung (2) nach Anspruch 1 und 2, **dadurch gekennzeichnet, dass** eine Batterie (3) als Energiequelle umfasst ist.

4. Sensoranordnung (2) nach Anspruch 1 bis 3, **dadurch gekennzeichnet, dass** sie eine Anzeige (1) umfasst.

5. Sensoranordnung (2) nach einem der vorherigen Ansprüche, **dadurch gekennzeichnet, dass** sie eine Auswertelektronik (4) umfasst.

6. Verfahren zur Herstellung einer Sensoranordnung (2) nach den Ansprüchen 1 bis 5, **gekennzeichnet durch** folgende Schritte:
- der erste Magnetsensor (5.1) wird in der Sensoranordnung (2) platziert;
- der zweite Magnetsensor (5.2) wird entsprechend in einem Abstand (a) in der Sensoranordnung(2) angebracht.

7. Verfahren nach Anspruch 1 bis 5, **dadurch gekennzeichnet, dass** in der Sensoranordnung (2) eine Batterie (3) als Energiequelle vorgesehen wird.

8. Verfahren nach Anspruch 1 bis 5, **dadurch gekennzeichnet, dass** in der Sensoranordnung (2) eine Anzeige (1) vorgesehen ist.
